# EUROPÄISCHE PATENTSCHRIFT

(11) **EP 0 875 084 B1**
(45) Veröffentlichungstag und Bekanntmachung des Hinweises auf die Patenterteilung: **11.08.1999**
(21) Anmeldenummer: 96944625.1
(22) Anmeldetag: 20.12.1996
(51) Int. Cl.: H02B 1/30, H05K 9/00

(54) **VORRICHTUNG ZUM ELEKTRISCH LEITENDEN VERBINDEN DES RAHMENGESTELLS ODER DES SCHRANKKORPUS EINES SCHALTSCHRANKES MIT DER TÜRE**
DEVICE FOR ELECTRICALLY CONNECTING THE FRAME OR CABINET HOUSING OF A SWITCHING CABINET WITH THE DOOR
DISPOSITIF DE CONNEXION ELECTRIQUE DU BATI OU DU CORPS D'UNE ARMOIRE DE DISTRIBUTION AVEC LA PORTE

(30) Priorität: 18.01.1996 DE 19601614; 06.07.1996 DE 29611787 U
(43) Veröffentlichungstag der Anmeldung: 04.11.1998
(73) Patentinhaber: Rittal-Werk Rudolf Loh GmbH & Co. KG, 35745 Herborn (DE)
(72) Erfinder: MÜNCH, Udo, D-35764 Sinn (DE); REUTER, Wolfgang, D-57299 Burbach 5 (DE); MÜLLER, Matthias, D-35708 Haiger (DE)
(74) Vertreter: Fleck, Hermann-Josef, Dr.-Ing.
(86) Internationale Anmeldenummer: EP9605787
(87) Internationale Veröffentlichungsnummer: WO9726689

(56) Entgegenhaltungen:
- DE-C- 3 611 693
- DE-C- 4 110 800
- DE-C- 19 540 300
- GB-A- 2 183 920
- US-A- 4 803 306

## Beschreibung

Die Erfindung betrifft eine Vorrichtung zum elektrisch leitenden Verbinden eines Rahmengestells oder eines Schrankkorpus eines Schaltschrankes oder Gehäuses mit einer Tür mittels Kontaktelementen, die mit der Türe zugekehrten Rahmenschenkeln des Rahmengestelles oder rahmenartiger Abkantungen des Schrankkorpus elektrisch leitend verbunden sind und sich federnd sowie elektrisch leitend an der geschlossenen Türe abstützen, wobei die Kontaktelemente als mehrfach abgekantete Kontaktfedern ausgebildet sind, wobei die Türe im Abstand zu den Rahmenschenkeln des Rahmengestells oder der rahmenartigen Abkantungen des Schrankkorpus eine elektrisch leitende Oberfläche aufweist und wobei die Halte-Abschnitte der Kontaktfedern außerhalb der Durchbrüche auf der der Tür zugekehrten Seite in mehrfach abgewinkelte Kontakt- und Stütz-Abschnitte übergehen, die zwischen der elektrisch leitenden Oberfläche und dem Rahmenschenkel oder der rahmenartigen Abkantung eingeführt sind und sich federnd an der elektrisch leitenden Oberfläche und dem Rahmenschenkel oder der rahmenartigen Abkantung abstützen.

Eine Vorrichtung dieser Art ist in der GB-A-2 183 920 als bekannt ausgewiesen. Bei dieser bekannten Vorrichtung sind zur Kontaktierung einer Tür an einem Schrankkorpus bzw. einem Rahmengestell federnde Kontaktelemente vorgesehen, die auf dem freien Ende eines Profilschenkels der Tür bzw. des Schrankkorpus aufgesteckt sind. Ein Abschnitt der Kontaktfedern, die mehrfache Abkantungen aufweisen, ist von der flachen Seite des jeweiligen Schenkels beabstandet, so daß sich eine federnde Abstützung des Kontaktelementes zur Tür ergibt.

Bei einer in der US-A-4,803,306 gezeigten weiteren Vorrichtung zum elektrisch leitenden Verbinden einer Seitenwand mit einem Gehäusekorpus ist ebenfalls ein federndes Kontaktelement vorgesehen. Das Kontaktelement weist zwei mit Haltekrallen versehene Halte-Abschnitte auf, die in einen Durchbruch des Gehäusekorpus eingesetzt sind.

Bei weiteren bekannten Vorrichtungen dieser Art wird ein Kontaktstreifen mit vielen Kontaktzungen auf einen Steg des Rahmenschenkels oder Schrankkorpus aufgesteckt. Dabei muß der Steg zumindest im Bereich der Aufsteckfläche eine elektrisch leitende Oberfläche aufweisen. Dasselbe gilt für die Türe in dem Bereich, in dem sich die Kontaktzungen an der Türe federnd abstützen. Dies bedeutet aber, daß der Schaltschrank mit der Türe entsprechend für diese Kontaktierung vorbereitet sein muß. Bei der Ausführung der Oberflächenschutzschicht sind daher besondere Vorkehrungen zu treffen, damit diese Bereiche von Rahmengestell oder Schrankkorpus und Türe frei bleiben bzw. mit einem besonders elektrisch gut leitenden Belag versehen werden. Diese Vorgehensweise verteuert die Herstellung des Schaltschrankes beachtlich. Außerdem ist die Kontaktierung nachträglich an einem bereits handelsüblichen, mit einer Oberflächenschutzschicht versehenen Schaltschrank, nicht möglich.

Es ist daher Aufgabe der Erfindung, eine Vorrichtung der eingangs erwähnten Art zu schaffen, mit der es möglich ist, einen mit einer Oberflächenschutzschicht versehenen Schaltschrank auch nachträglich im Bereich der Schließseite der Türe zu kontaktieren.

Diese Aufgabe wird nach der Erfindung dadurch gelöst, daß die Kontaktfedern mit Halte-Abschnitten in einen Durchbruch des Rahmenschenkels oder der rahmenartigen Abkantungen des Schrankkorpus eingesteckt oder daran elektrisch leitend angeschraubt oder angenietet sind und mittels an den Halte-Abschnitten abstehender Haltekrallen unter Herstellung einer elektrisch leitenden Verbindung zum Rahmenschenkel oder Schrankkorpus in dem Durchbruch gehalten sind, daß zwei Kontakt-Abschnitte eine Kontaktkante bilden, mit der die Kontaktfeder am Türrahmen anliegt und daß der Stützabschnitt der Kontaktfeder parallel zur Anlageseite des Rahmenschenkels oder der rahmenartigen Abkantung ausgerichtet ist und einen Abstand zur Kontaktkante aufweist, der etwas größer ist als der Abstand zwischen dem Türrahmen und dem Rahmenschenkel oder der rahmenartigen Abkantung.

Beim Einstecken der Kontaktfeder in den Durchbruch des Rahmenschenkels oder der rahmenartigen Abkantung durchstreifen die Halterahmen im Bereich des Durchbruchs die Oberflächenschutzschicht und stellen auf einfachste Weise eine elektrisch leitende Verbindung zwischen dem Rahmengestell oder dem Schrankkorpus und der Kontaktfeder her. Außerdem legen die Haltekrallen die Kontaktfeder unverlierbar an dem Rahmenschenkel oder der rahmenartigen Abkantung fest. Die Türe hat eine elektrisch leitende Oberfläche. Dies kann beispielsweise ein auf der Innenseite der Tür angeschraubter, mit dieser in elektrisch leitender Verbindung stehender Türrahmen sein.

Die zwischen den Türrahmen und den Rahmenschenkeln oder rahmenartigen Abkantungen eingeführten Kontakt- und Stütz-Abschnitte der Kontaktfeder bringen durch ihre federnde Abstützung an beiden Teilen einen ausreichenden Kontaktdruck am Türrahmen, wenn die Türe geschlossen ist.

Damit die Kontaktfeder mit festem Halt in den Durchbruch des Rahmenschenkels oder der rahmenartigen Abkantung eingebracht werden kann, ist weiterhin vorgesehen, daß die Halte-Abschnitte in ihrer Breite auf die Abmessung der vorzugsweise rechteckigen Durchbrüche der Rahmenschenkel des Rahmengestells oder den rahmenartigen Abkantungen des Schrankkorpus angepaßt sind und daß die Haltekrallen etwa dreieckförmig ausgebildet sind und den Durchbruch des Rahmenschenkels oder rahmenartigen Abkantungen teilweise hintergreifen.

Ist vorgesehen, daß die Haltekrallen über die Schmalseiten und die einander abgekehrten Außenseiten der Halte-Abschnitte vorstehen, dann wird beim Einstecken der Kontaktfeder in den Durchbruch die Oberflächenschutzschicht am Rahmenschenkel oder an der rahmenartigen Abkantung sicher durchstoßen und die Haltekrallen liegen unter Federspannung elektrisch leitend am Rahmenschenkel oder der rahmenartigen Abkantung an.

Der Halt der Kontaktfeder im Durchbruch des Rahmenschenkels oder der rahmenartigen Abkantung kann dadurch noch verbessert werden, daß der der Türe abgekehrte Halte-Abschnitt der Kontaktfeder außerhalb des Durchbruchs des Rahmenschenkels oder der rahmenartigen Abkantung des Schrankkorpus in einem am Rahmenschenkel anliegenden Anlage-Abschnitt übergeht und daß die Anlage-, Kontakt- und Stützabschnitte der Kontaktfeder breiter sind als die Halte-Abschnitte.

Ist nach einer weiteren Ausgestaltung vorgesehen, daß an den Übergängen von den Halte-Abschnitten zu dem Anlage-Abschnitt und den Kontakt-Abschnitten Kontaktkrallen ausgebildet sind, die sich unter Herstellung elektrisch leitender Verbindungen am Rahmenschenkel oder an der rahmenartigen Abkantung abstützen, dann ist die Anzahl der Kontaktstellen zwischen der Kontaktfeder und den Rahmenschenkeln oder der rahmenartigen Abkantung auf einfache Weise vergrößert.

Damit die Kontaktfeder den Schließvorgang der Türe nicht beeinträchtigt, sieht eine Ausgestaltung vor, daß die zwei Kontakt-Abschnitte vorzugsweise einen stumpfen Winkel einschließen und eine Kontaktkante bilden, mit der die Kontaktfeder am Türrahmen anliegt. Der Türrahmen gleitet beim Schließvorgang an dem einen Kontakt-Abschnitt entlang, bis sich die Kontaktkante an der zum Rahmenschenkel oder zur rahmenartigen Abkantung parallelen Seite des Türrahmens abstützt, wobei die Vorspannung in den Kontakt- und Stütz-Abschnitten erzeugt wird. Damit diese Vorspannung tatsächlich entsteht, ist vorgesehen, daß der Stützabschnitt der Kontaktfeder parallel zur Anlageseite des Rahmenschenkels oder der rahmenartigen Abkantung ausgerichtet ist und einen Abstand zur Kontaktkante aufweist, der etwas größer ist als der Abstand zwischen dem Türrahmen und dem Rahmenschenkel oder der rahmenartigen Abkantung.

Damit der Stütz-Abschnitt dabei ohne Beeinträchtigung am Rahmenschenkel oder der rahmenartigen Abkantung gleiten kann, ist der Stützabschnitt von den Halte-Abschnitten aus gesehen hinter den Kontaktabschnitten abgebogen und läuft in einen End-Abschnitt aus, der in Richtung zu den Kontakt-Abschnitten eingebogen ist.

Alternativ kann vorgesehen sein, daß der Stützabschnitt zwischen dem der Tür zugewandten Halte-Abschnitt und dem einen Kontaktabschnitt angeordnet ist.

Die Erfindung wird anhand eines in der Zeichnung dargestellten Ausführungsbeispiels näher erläutert. Es zeigen:
- Fig. 1: im Teilquerschnitt eine mittels einer erfindungsgemäßen Kontaktfeder hergestellte, elektrisch leitende Verbindung zwischen einer geschlossenen Türe und dem Rahmengestell eines Schaltschrankes,
- Fig. 2 und 3: die daher verwendete Kontaktfeder in zwei um 90° versetzten Ansichten, und
- Fig. 4 bis 6: eine perspektivische Darstellung, einen Einbauvorgang sowie einen eingebauten Zustand einer weiteren Ausführungsform der Kontaktfeder.

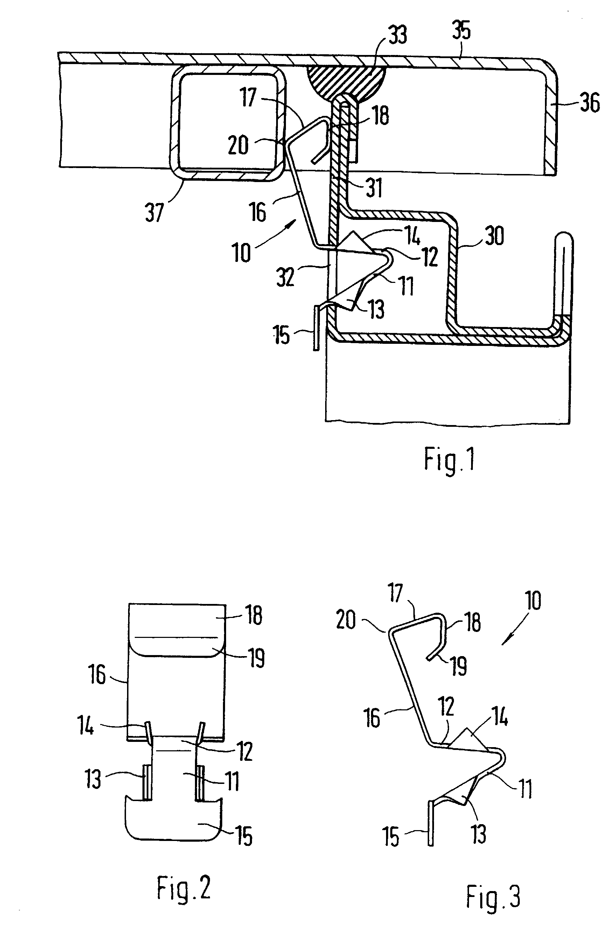

Wie der Teilabschnitt nach Fig. 1 erkennen läßt, ist auf der Innenseite der Türe 35 im Abstand vom abgekanteten Rand 36 ein Türrahmen 37 angebracht, der aus Profilabschnitten, im Ausführungsbeispiel Vierkant-Hohlprofilabschnitten, zusammengesetzt ist. Dieser Türrahmen 37 ist in der Regel mit der Türe 35 verschraubt, wozu die Schrauben auf der Innenseite der Türe 35 aufgeschweißt sind. Daher steht der Türrahmen 37 mit der Türe 35 in elektrisch leitender Verbindung. Der Türrahmen 37 kann daher auch leicht ausgetauscht werden, wenn er keine elektrisch leitende Oberfläche besitzt, wie nunmehr erforderlich ist.

Bei geschlossener Türe 35 steht der Türrahmen 37 an allen vier Seiten im Abstand zu Rahmenschenkeln 30 des Rahmengestells. Dabei können die Rahmenschenkel 30 auch durch Abkantungen der zugeordneten Seitenwände eines Schrankkorpus gebildet sein.

Die Rahmenschenkel 30 weisen eine senkrecht zur Türe 35 stehende Profilseite auf, die in einem Dichtungssteg 31 ausläuft, der sich an einem Dichtungselement 33 abstützt, das auf der Innenseite der Türe 35 aufgeschäumt sein kann. In der Profilseite des Rahmenschenkels 30 ist eine Reihe von vorzugsweise rechteckigen Durchbrüchen 32 eingebracht, so daß mit Kontaktfedern 10 an mehreren Stellen aller vier Seiten eine Kontaktierung vorgenommen werden kann.

Für die Kontaktierung wird eine Kontaktfeder 10 verwendet, wie sie in den Fig. 2 und 3 dargestellt ist. Die Kontaktfeder 10 ist ein einfaches Stanz- und Biegeteil aus einem Federstahlband. Zwei im spitzen Winkel zueinander stehende Halte-Abschnitte 11 und 12 sind an ihren Schmalseiten mit Haltekrallen 13 und 14 versehen, die an den Schmalseiten und den Außenseiten der Halte-Abschnitte 11 und 12 vorstehen. Ist die Breite der Halte-Abschnitte 11 und 12 an die Abmessung des Durchbruches 32 im Rahmenschenkel 30 angepaßt, dann wird beim Einstecken der Halte-Abschnitte 11 und 12 in einem Durchbruch 32 durch die Haltekrallen 13 und 14 eine Art Rastbefestigung erreicht, so daß die Kontaktfeder 10 unverlierbar am Rahmenschenkel 30 festgelegt ist. Die Haltekrallen 13 und 14 durchstoßen dabei die Oberflächenschutzschicht des Rahmenschenkels 30 und liegen unter Vorspannung elektrisch leitend im Bereich des Durchbruches 32 am Rahmenschenkel 30 an.

Der der Türe 35 abgekehrte Halte-Abschnitt 11 läuft in einen Anlage-Abschnitt 15 aus, der breiter ist als der Halte-Abschnitt 11 und den Halt der Kontaktfeder 10 durch Anlage am Rahmenschenkel 30 verbessern kann. Außerdem können am Übergang zum Anlage-Abschnitt 15 Kontaktkrallen ausgebildet sein, die sich federnd und mit elektrischem Kontakt am Rahmenschenkel 30 abstützen.

Der der Türe 35 zugekehrte Halte-Abschnitt 12 läuft außerhalb des Durchbruches 32 in Kontakt-Abschnitte 16 und 17, einen Stütz-Abschnitt 18 und einen End-Abschnitt 19 aus. Die Kontakt-Abschnitte 16 und 17, der Stütz-Abschnitt 18 und der End-Abschnitt 19 sind zwischen dem Türrahmen 37 und dem Rahmenschenkel 30 eingeführt. Dabei bilden die Kontakt-Abschnitte 16 und 17 eine dem Türrahmen 37 zugekehrte Kontaktkante 20. Der Kontakt-Abschnitt 17 geht in den parallel zum Steg 31 des Rahmenschenkels 30 stehenden Stütz-Abschnitt 18 über, der wiederum in den zu den Kontakt-Abschnitten 16 und 17 eingebogenen End-Abschnitt 19 ausläuft.

Der Abstand zwischen der Kontaktkante 20 und dem Stütz-Abschnitt 18 ist bei geöffneter Türe 35 größer als der Abstand zwischen dem Türrahmen 37 und dem Rahmenschenkel 30 bei geschlossener Türe 35. Beim Schließen der Türe 35 gleitet der Tührrahmen 37 am Kontakt-Abschnitt 17 hoch und drückt beim Passieren der Kontaktkante 20 die Kontaktfeder 10 zusammen, so daß ein ausreichender Kontaktdruck entsteht. Dabei kann der Stütz-Abschnitt 18 ohne Beeinträchtigung am Steg 31 des Rahmenschenkels 30 eine Gleitbewegung ausführen.

Auch die Kontakt-Abschnitte 16 und 17, der Stütz-Abschnitt 18 und der End-Abschnitt 19 sind breiter als der Halte-Abschnitt 12 und am Übergang von dem Halteabschnitt 12 zum Kontakt-Abschnitt 16 können Kontaktkrallen ausgebildet sein, die sich im Bereich des Durchbruches 32 am Rahmenschenkel 30 federnd abstützen, die Oberflächenschutzschicht durchstoßen und weitere Kontaktstellen bilden. Bei geöffneter Türe 35 bleibt die Kontaktfeder 10 am Rahmenschenkel 30 gehalten und die Kontakt-Abschnitte 16 und 17 nehmen wieder ihre entspannte Ausgangsstellung ein.

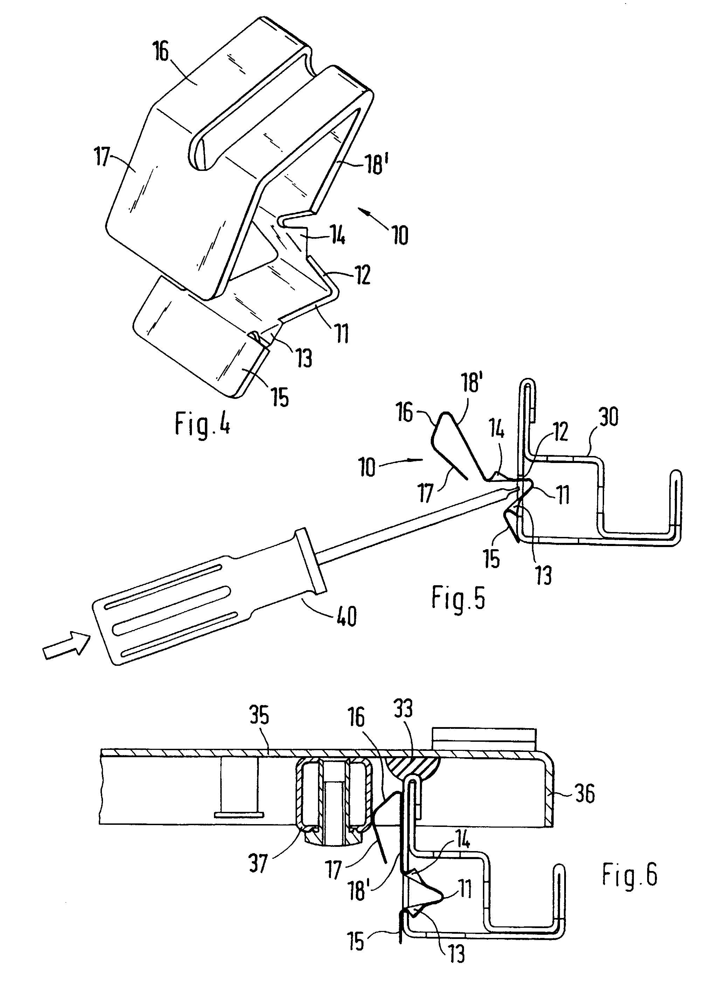

In den Fig. 4 bis 6 ist eine weitere Ausführungsform der Kontaktfeder 10 gezeigt, wobei Fig. 4 eine perspektivische Ansicht, Fig. 5 die Vorgehensweise beim Einsetzen der Kontaktfeder 10 mit einem einfachen Werkzeug 40 und Fig. 6 einen eingebauten Zustand zeigen. Bei dieser Ausführungsform ist der Stütz-Abschnitt 18! zwischen den der Tür 35 zugewandten Halte-Abschnitt 12 und dem einen Kontakt-Abschnitt 16 angeordnet, und der Kontakt-Abschnitt 16 ist im wesentlichen V-förmig von dem Stütz-Abschnitt 18' abgebogen, so daß er von der Tür 35 weggerichtet ist.

Die Kontaktfedern 10, 10' können, wenn keine Durchbrüche 32 vorgesehen sind, an dem Rahmenschenkel 30 elektrisch leitend angeschraubt oder angenietet sein.

Anstelle des Rahmenschenkels 30 kann auch eine rahmenartige Abkantung eines Schrankkorpus treten, die ebenfalls Durchbrüche aufweist und mit gleichen Kontaktfedern elektrisch leitende Verbindungen zur Türe zuläßt.

## Patentansprüche

1. Vorrichtung zum elektrisch leitenden Verbinden eines Rahmengestells oder eines Schrankkorpus eines Schaltschrankes oder Gehäuses mit einer Tür (35) mittels Kontaktelementen, die mit der Türe (35) zugekehrten Rahmenschenkeln (30) des Rahmengestelles oder rahmenartiger Abkantungen des Schrankkorpus elektrisch leitend verbunden sind und sich federnd sowie elektrisch leitend an der geschlossenen Türe abstützen, wobei die Kontaktelemente als mehrfach abgekantete Kontaktfedern (10) ausgebildet sind, wobei die Türe (35) im Abstand zu den Rahmenschenkeln (30) des Rahmengestells oder der rahmenartigen Abkantungen des Schrankkorpus eine elektrisch leitende Oberfläche (37) aufweist und wobei die Halte-Abschnitte (12) der Kontaktfedern (10) außerhalb der Durchbrüche (32) auf der der Tür (35) zugekehrten Seite in mehrfach abgewinkelte Kontakt- und Stütz-Abschnitte (16, 17 und 18) übergehen, die zwischen der elektrisch leitenden Oberfläche (37) und dem Rahmenschenkel (30) oder der rahmenartigen Abkantung eingeführt sind und sich federnd an der elektrisch leitend Oberfläche (37) und dem Rahmenschenkel (30) oder der rahmenartigen Abkantung abstützen,
dadurch gekennzeichnet,
daß die Kontaktfedern (10) mit Halte-Abschnitten (11,12) in einen Durchbruch (32) des Rahmenschenkels (30) oder der rahmenartigen Abkantungen des Schrankkorpus eingesteckt oder daran elektrisch leitend angeschraubt oder angenietet sind und mittels an den Halte-Abschnitten (11,12) abstehender Haltekrallen (13,14) unter Herstellung einer elektrisch leitenden Verbindung zum Rahmenschenkel (30) oder Schrankkorpus in dem Durchbruch (32) gehalten sind,
daß zwei Kontakt-Abschnitte (16,17) eine Kontaktkante (20) bilden, mit der die Kontaktfeder (10) am Türrahmen (37) anliegt und
daß der Stützabschnitt (18) der Kontaktfeder (10) parallel zur Anlageseite des Rahmenschenkels (30) oder der rahmenartigen Abkantung ausgerichtet ist und einen Abstand zur Kontaktkante (20) aufweist, der etwas größer ist als der Abstand zwischen dem Türrahmen (35) und dem Rahmenschenkel (30) oder der rahmenartigen Abkantung.

2. Vorrichtung nach Anspruch 1,
dadurch gekennzeichnet,
daß die elektrisch leitende Oberfläche ein auf die Innenseite der Tür (35) aufgesetzter Türrahmen (37) mit elektrisch leitender Oberfläche ist.

3. Vorrichtung nach Anspruch 1,
dadurch gekennzeichnet,
daß die Halte-Abschnitte (11, 12) in ihrer Breite auf die Abmessung der vorzugsweise rechteckigen Durchbrüche (32) der Rahmenschenkel (30) des Rahmengestells oder den rahmenartigen Abkantungen des Schrankkorpus angepaßt sind.

4. Vorrichtung nach einem der Ansprüche 1 bis 3,
dadurch gekennzeichnet,
daß die Haltekrallen (13, 14) etwa dreieckförmig ausgebildet sind und den Durchbruch (32) des Rahmenschenkels (30) oder der rahmenartigen Abkantungen teilweise hintergreifen.

5. Vorrichtung nach einem der Ansprüche 1 bis 4,
dadurch gekennzeichnet,
daß die Haltekrallen (13, 14) über die Schmalseiten und die einander abgekehrten Außenseiten der Halte-Abschnitte (11, 12) vorstehen.

6. Vorrichtung nach einem der Ansprüche 1 bis 5,
dadurch gekennzeichnet,
daß der der Türe (35) abgekehrte Halte-Abschnitt (11) der Kontaktfeder (10) außerhalb des Durchbruchs (32) des Rahmenschenkels (30) oder der rahmenartigen Abkantung des Schrankkorpus in einen am Rahmenschenkel (30) anliegenden Anlage-Abschnitt (15) übergeht.

7. Vorrichtung nach einem der Ansprüche 1 bis 6,
dadurch gekennzeichnet,
daß die Anlage-, Kontakt- und Stützabschnitte (15; 16, 17 und 18, 19) der Kontaktfeder (10) breiter sind als die Halte-Abschnitte (11, 12).

8. Vorrichtung nach einem der Ansprüche 1 bis 7,
dadurch gekennzeichnet,
daß an den Übergängen von den Halte-Abschnitten (11, 12) zu dem Anlage-Abschnitt (15) und den Kontakt-Abschnitten (16, 17) Kontaktkrallen ausgebildet sind, die sich unter Herstellung elektrisch leitender Verbindungen am Rahmenschenkel (30) oder an der rahmenartigen Abkantung abstützen.

9. Vorrichtung nach einem der Ansprüche 1 bis 8,
dadurch gekennzeichnet,
daß die Kontakt-Abschnitte (16, 17) vorzugsweise einen stumpfen Winkel einschließen und eine Kontaktkante (20) bilden, mit der die Kontaktfeder (10) am Türrahmen (37) anliegt.

10. Vorrichtung nach einem der vorhergehenden Ansprüche,
dadurch gekennzeichnet,
daß der Stütz-Abschnitt (18) von den Halte-Abschnitten (11,12) aus gesehen hinter den Kontakt-Abschnitten (16,17) als von der Tür (35) weggerichteter Abschnitt abgebogen ist, und in einem End-Abschnitt (19) ausläuft, der in Richtung zu den Kontakt-Abschnitten (16, 17) eingebogen ist.

11. Vorrichtung nach einem der Ansprüche 1 bis 9,
dadurch gekennzeichnet,
daß der Stützabschnitt (18') zwischen dem der Tür (35) zugewandten Halte-Abschnitt (12) und dem einen Kontaktabschnitt (16) angeordnet ist.

## Claims

1. Device for connecting so as to be electrically conductive a framework or a cabinet carcass of a switchgear cabinet or housing with a door (35), by means of contact members which are connected so as to be electrically conductive with frame members (30) of the framework or frame-like bent-over portions of the cabinet carcass facing the door, and are supported resiliently and electrically conductive on the closed door, the contact members being configured as multiply bent-over contact springs (10), the door (35) having an electrically conductive surface (37) at a spacing from the frame members (30) of the framework or the frame-like bent-over portions of the cabinet carcass, and the holding portions (12) of the contact springs (10) merging outside the openings (32) on the side facing the door (35) into multiply bent-over contact and support portions (16, 17 and 18) which are inserted between the electrically conductive surface (37) and the frame member (30) or the frame-like bent-over portion, and are resiliently supported on the electrically conductive surface (37) and the frame member (30) or the frame-like bent-over portion,
**characterised in that**
the contact springs (10) are inserted with holding portions (11, 12) into an opening (32) in the frame member (30) or in the frame-like bent-over portions of the cabinet carcass, or are screwed or welded thereto so as to be electrically conductive, and are held in the opening (32) by means of holding claws (13, 14) which project from the holding portions (11, 12), producing an electrically conductive connection with the frame member (30) or cabinet carcass,
in that two contact portions (16, 17) form a contact edge (20) with which the contact spring (10) abuts against the door frame (37) and
in that the support section (18) of the contact spring (10) is aligned parallel to the abutment side of the frame member (30) or of the frame-like bent-over portion and is at a spacing from the contact edge (20) which is slightly larger than the distance between the door frame (35) and the frame member (30) or the frame-like bent-over portion.

2. Device according to claim 1,
**characterised in that**
the electrically conductive surface is a door frame (37) with an electrically conductive surface which is placed on the inner side of the door (35).

3. Device according to claim 1,
**characterised in that**
the holding portions (11, 12) are matched in width to the dimension of the preferably rectangular openings (32) in the frame member (30) of the framework or the frame-like bent-over portions of the cabinet carcass.

4. Device according to one of claims 1 to 3,
**characterised in that**
the holding claws (13, 14) are configured in a roughly triangular shape and grip partially behind the opening (32) of the frame member (30) or of the frame-like bent-over portions.

5. Device according to one of claims 1 to 4,
**characterised in that**
the holding claws (13, 14) project beyond the narrow sides and the outer sides, which face away from one another, of the holding portions (11, 12).

6. Device according to one of claims 1 to 5,
**characterised in that**
the holding portion (11), facing away from the door (35), of the contact spring (10) merges outside the opening (32) in the frame member (30) or in the frame-like bent-over portion of the cabinet carcass into an abutment portion (15) abutting against the frame member (30).

7. Device according to one of claims 1 to 6,
**characterised in that**
the abutment, contact and support portions (15; 16, 17 and 18, 19) of the contact spring (10) are broader than the holding portions (11, 12).

8. Device according to one of claims 1 to 7,
**characterised in that** there are formed on the transitional regions from the holding portions (11, 12) to the abutment portion (15) and the contact portions (16, 17) contact claws which are supported on the frame member (30) or on the frame-like bent-over portion, producing electrically conductive connections.

9. Device according to one of claims 1 to 8,
**characterised in that**
the contact portions (16, 17) preferably enclose an obtuse angle and form a contact edge (20) with which the contact spring (10) abuts against the door frame (37).

10. Device according to one of the preceding claims,
**characterised in that**
the support section (18), seen from the holding portions (11, 12), is bent away behind the contact portions (16, 17) as a portion directed away from the door (35), and terminates in an end portion (19) which is bent inwardly towards the contact portions (16, 17).

11. Device according to one of claims 1 to 9,
**characterised in that**
the support section (18') is disposed between the holding portion (12) facing the door (35) and the one contact portion (16).

## Revendications

1. Dispositif de connexion électrique du bâti ou du corps d'une armoire de distribution ou d'un boîtier avec une porte (35) au moyen d'éléments de contact, qui sont reliés à conductivité électrique aux ailes d'encadrement (30), orientées vers la porte (35), du bâti ou à des coudes en forme de cadre du corps de l'armoire et qui s'appuient sous contrainte élastique et à conductivité électrique sur la porte, dispositif dans lequel les éléments de contact ont la forme de lames de contact (10) à cintrages multiples et où la porte (35) présente, à distance des ailes d'encadrement (30) du bâti ou des coudes en forme de cadre du corps de l'armoire, une surface à conductivité électrique (37) et où les tronçons de support (12) des lames de contact (10), en dehors des percements (32) et au côté orienté vers la porte (35), se prolongent par des tronçons de contact et d'appui (16, 17 et 18) à cintrages multiples, tronçons qui sont introduits entre la surface à conductivité électrique (37) et l'aile d'encadrement (30) ou le coude en forme de cadre et s'appuient sous contrainte élastique sur la surface à conductivité électrique (37) et l'aile d'encadrement (30) ou sur le coude en forme de cadre,
caractérisé
en ce que les lames de contact (10) sont par des tronçons de support (11, 12) enfichées dans un percement (32) de l'aile d'encadrement (30) ou des coudes en forme de cadre du corps de l'armoire et y sont fixées à conductivité électrique par des vis ou des rivets et sont au moyen de griffes de support (13, 14) maintenues dans le percement (32) avec établissement d'une connexion électrique avec l'aile d'encadrement (30) ou avec le corps de l'armoire,
en ce que deux tronçons de contact (16, 17) forment une arête de contact (20), par laquelle la lame de contact (10) s'applique sur le cadre (37) de la porte,
en ce que le tronçon d'appui (18) de la lame de contact (10) est orienté parallèlement à la face d'application de l'aile d'encadrement (30) ou du coude en forme de cadre et présente une certaine distance par rapport à l'arête de contact (20), distance qui est légèrement supérieure à la distance entre le cadre de la porte (35) et l'aile d'encadrement (30) ou le coude en forme de cadre.

2. Dispositif suivant la revendication 1,
caractérisé
en ce que la surface à conductivité électrique et un châssis de porte (37) posé sur la face intérieure de la porte (35), châssis qui présente une surface à conductivité électrique.

3. Dispositif suivant la revendication 1,
caractérisé
en ce que les tronçons de support (11, 12) sont, en ce qui concerne leur largeur, adaptés à la configuration des percements (32) de préférence rectangulaires des ailes d'encadrement (30) du bâti ou des coudes en forme de cadre du corps de l'armoire.

4. Dispositif suivant l'une quelconque des revendications de 1 à 3,
caractérisé
en ce que les griffes de support (13, 14) sont de forme sensiblement triangulaire et s'engagent partiellement derrière le percement (32) de l'aile d'encadrement ou des coudes en forme de cadre.

5. Dispositif suivant l'une quelconque des revendications de 1 à 4,
caractérisé
en ce que les griffes de support (13, 14) font protubérance par rapport aux petits côtés et par rapport aux faces extérieures non orientées l'une vers l'autre des tronçons de support (11, 12).

6. Dispositif suivant l'une quelconque des revendications de 1 à 5,
caractérisé
en ce que le tronçon de support (11) de la lame de contact (10) non orienté vers la porte (35) se prolonge, à l'extérieur du percement (32) de l'aile d'encadrement (30) ou du coude en forme de cadre du corps de l'armoire, par un tronçon d'application (15) appliqué à l'aile d'encadrement (30).

7. Dispositif suivant l'une quelconque des revendications de 1 à 6,
caractérisé
en ce que les tronçons d'application, de contact et d'appui (15; 16, 17 et 18, 19) de la lame de contact (10) sont plus larges que les tronçons de support (11, 12).

8. Dispositif suivant l'une quelconque des revendications de 1 à 7,
caractérisé
en ce que dans les zones de transition des tronçons de support (11, 12) vers le tronçon d'application (15) et vers les tronçons de contact (16, 17) sont formées des griffes d contact qui s'appuient sur l'aile d'encadrement (30) ou le coude en forme de cadre, avec établissement de connexions électriques.

9. Dispositif suivant l'une quelconque des revendications de 1 à 8,
caractérisé
en ce que les tronçons de contact (16, 17) forment de préférence un angle obtus et constituent une arête de contact (20) par laquelle la lame de contact (10) s'applique sur le châssis de porte (37).

10. Dispositif suivant l'une quelconque des revendications précédentes,
caractérisé
en ce que vu depuis les tronçons de support (11, 12), le tronçon d'appui (18) est derrière les tronçons de contact (16, 17), cintré pour former un tronçon non orienté vers la porte (35) et se termine par un tronçon terminal (19), qui est cintré en direction des tronçons de contact (16, 17).

11. Dispositif suivant l'une quelconque des revendications de 1 à 9,
caractérisé
en ce que le tronçon d'appui (18') est disposé entre le tronçon de support (12) orienté vers la porte (35) et l'un (16) des tronçons de contact.
